# EUROPÄISCHE PATENTSCHRIFT

(11) **EP 1 488 508 B1**
(45) Veröffentlichungstag und Bekanntmachung des Hinweises auf die Patenterteilung: **13.07.2005**
(21) Anmeldenummer: 03720131.6
(22) Anmeldetag: 25.02.2003
(51) Int. Cl.: H03C 3/09

(54) **ZWEIPUNKT-MODULATORANORDNUNG**
TWO-POINT MODULATOR ASSEMBLY
ENSEMBLE MODULATEUR A DEUX POINTS

(30) Priorität: 26.03.2002 DE 10213525
(43) Veröffentlichungstag der Anmeldung: 22.12.2004
(73) Patentinhaber: Infineon Technologies AG, 81669 München (DE)
(72) Erfinder: HERZINGER, Stefan, 80686 München (DE); MÄRZINGER, Günter, A-4161 Ulrichsberg (AT); NEURAUTER, Burkhard, A-4040 Linz (AT); WEIGEL, Robert, 90409 Nürnberg (DE)
(74) Vertreter: Epping Hermann & Fischer
(86) Internationale Anmeldenummer: PCT/DE2003/000602
(87) Internationale Veröffentlichungsnummer: WO 2003/081868

(56) Entgegenhaltungen:
- EP-A- 1 063 766
- WO-A-99/07065
- GB-A- 2 317 512
- US-A- 5 834 987

## Beschreibung

Die vorliegende Erfindung betrifft eine Zweipunkt-Modulatoranordnung.

Zweipunkt-Modulatoren weisen normalerweise eine Phasenregelschleife (Phase Locked Loop, PLL) auf, welche an zwei Punkten mit einem Modulationssignal zur Phasen- und/oder Frequenzmodulation eines Trägersignals beaufschlagt wird. Dabei ist üblicherweise ein Punkt mit Hochpaß-Verhalten und ein Punkt mit Tiefpaß-Verhalten innerhalb der Phasenregelschleife vorgesehen, an denen jeweils das Modulationssignal eingebracht wird. Am Ausgang des Phasenregelkreises ergibt sich ein überlagertes Signal, mit dem Vorteil, daß die Schleife ein frequenzunabhängiges Übertragungsverhalten zeigt.

Zweipunkt-Modulatoranordnungen sind beispielsweise in dem Dokument DE 199 29 167 A1 angegeben. Dort ist zwischen Schleifenfilter und Steuereingang eines VCO ein Summationspunkt vorgesehen, an dem das Modulationssignal mit dem Ausgangssignal des Schleifenfilters verknüpft wird. Hierbei ist ein Hochpaß-Übertragungsverhalten für die Modulationsfrequenz gebildet. Im Rückführungszweig der Phasenregelschleife ist ein Frequenzteiler vorgesehen, dessen Teilerverhältnis ebenfalls durch das Modulationssignal unter Bildung eines Tiefpaß-Übertragungsverhaltens für die Modulationsfrequenz eingespeist wird.

Insgesamt ermöglicht das Zweipunkt-Modulationsprinzip eine Modulation mittels einer Phasenregelschleife mit Modulationssignalen, deren Bandbreite größer ist als die Bandbreite der Phasenregelschleife selbst.

Für den bekannten Zweipunkt-Modulator ist es bislang eine Voraussetzung, daß der spannungsgesteuerte Oszillator zwei Steuereingänge umfaßt, nämlich einen, der vom Ausgang des Phasenvergleichers über das Schleifenfilter angesteuert wird und einen zweiten, der vom Modulationssignal angesteuert wird.

Alternativ könnte in die Phasenregelschleife ein zusätzliches Verknüpfungsglied zum Verknüpfen des Modulationssignals mit dem Ausgangssignal des Schleifenfilters vorgesehen sein, was jedoch einen zusätzlichen Aufwand bedeutet und die Rauscheigenschaften des Modulators signifikant verschlechtert.

Aufgabe der vorliegenden Erfindung ist es, eine Zweipunkt-Modulatoranordnung anzugeben, welche für gesteuerte Oszillatoren mit lediglich einem Steuereingang geeignet ist und gute Rauscheigenschaften hat.

Erfindungsgemäß wird die Aufgabe gelöst durch eine Zweipunkt-Modulatoranordnung, aufweisend
- einen Modulationseingang zum Zuführen von Modulationsdaten,
- einen Ausgang zum Ableiten eines modulierten Signals, und
- einen Phasenregelkreis,
   mit einem Phasenvergleicher, der einen ersten und einen zweiten Eingang und einen Ausgang umfaßt,
   mit einem steuerbaren Oszillator, der einen Steuereingang und einen Ausgang umfaßt,
   mit einem Schleifenfilter, das einen Eingang hat, der mit dem Ausgang des Phasenvergleichers gekoppelt ist, und das einen Ausgang hat, der mit dem Eingang des Oszillators verbunden ist, und das einen weiteren Eingang hat, der an einem mit dem Schleifenfilter verbundenen Einkoppelglied gebildet und mit dem Modulationseingang der
   Modulatoranordnung gekoppelt ist, wobei das Einkoppelglied zwischen einen Schaltungsknoten des Schleifenfilters und einen Bezugspotentialanschluß geschaltet ist, und
   mit einem Rückkopplungspfad des Phasenregelkreises, wobei im Rückkopplungspfad ein Frequenzteiler angeordnet ist, der einen Eingang, welcher mit dem Ausgang des Oszillators verbunden ist, einen Ausgang, welcher mit dem ersten Eingang des Phasenvergleichers verbunden ist und einen Steuereingang zum Einstellen des Teilerverhältnisses, der mit dem Modulationseingang der Modulatoranordnung gekoppelt ist, aufweist.

Gemäß vorliegendem Prinzip kann, muß aber nicht notwendigerweise, der gesteuerte Oszillator lediglich einen Abstimm- oder Tuning-Eingang als Steuereingang haben. Dennoch ist gemäß vorliegendem Prinzip mit Vorteil eine Zweipunkt-Modulation ermöglicht, welche die Verarbeitung von Modulationssignalen mit hoher Bandbreite gestattet. Dabei kann die Bandbreite des Modulationssignals größer sein als die Bandbreite des Phasenregelkreises.

Die Erweiterung des Schleifenfilters, welches ohnehin normalerweise Bestandteil eines Phasenregelkreises ist, um einen weiteren Einkoppelpunkt hat den zusätzlichen Vorteil, daß der Zweipunkt-Modulator gute Rauscheigenschaften zeigt.

Gemäß der Erfindung ist das Einkoppelglied, welches einen der Einspeisepunkte für das Modulationssignal bildet, zwischen einen Fußpunkt des Schleifenfilters der Phasenregelschleife und einen Bezugspotentialanschluß der Modulatoranordnung geschaltet.

Das bevorzugt aus rein passiven Bauteilen aufgebaute Einkoppelglied erweitert das Schleifenfilter und ist bevorzugt so ausgelegt, daß das Modulationssignal mit einer ausreichenden Bandbreite an den Steuereingang des Oszillators übertragen werden kann.

Das erweiterte Schleifenfilter, welches eine Verknüpfung des unmittelbar zugeführten Modulationssignals und des über den Rückkopplungspfad der Regelschleife zugeführten Modulationssignals ermöglicht, beeinflußt die Schleifendynamik des Regelkreises nur gering.

Die erfindungsgemäße Erweiterung des Schleifenfilters, also das Einkoppelglied, umfaßt bevorzugt eine Parallelschaltung aus einem Kondensator und aus einer Serienschaltung aus einem Kondensator und einem Widerstand. Der Hochpaß-Einkoppelpunkt ist dabei bevorzugt innerhalb der Serienschaltung zwischen Widerstand und Kondensator gebildet.

Da die Modulationsdaten bevorzugt digital vorliegen, ist zur Ansteuerung des Einkoppelgliedes bevorzugt ein Digital-Analog-Wandler vorgesehen und entsprechend vorgeschaltet. Zur Ansteuerung des Frequenzteilers im Rückkopplungspfad des Regelkreises ist bevorzugt ein Delta-Sigma-Modulator, bevorzugt ausgebildet als MASH-Modulator, vorgesehen, der den Frequenzteiler mit dem Modulationssignal an dem Tiefpaß-Einkoppelpunkt ansteuert. Der Frequenzteiler im Rückkopplungspfad ist dabei bevorzugt als sogenannter Multi-Modulus-Teiler ausgebildet. Der Frequenzteiler ist so ausgebildet, daß bevorzugt nicht nur eine Frequenzteilung durch ganze Zahlen, sondern im zeitlichen Mittel auch mit Bruchzahlen möglich ist.

Am Modulationseingang kann anstelle eigentlicher Modulationsdaten auch ein Sprungsignal angelegt werden. Hierdurch ist es möglich, daß der Modulator besonders schnell auf eine neue Frequenz gebracht werden kann. Der Phasenregelkreis rastet demnach besonders schnell auf einen neuen Kanal ein. Die Geschwindigkeit, mit der der Modulator den Kanal wechseln kann, ist dabei höher als der PLL-Bandbreite entsprechen. Das Sprungsignal wird dabei nach einem eventuell vorhandenen Gauss-Filter eingespeist.

Weitere Einzelheiten und vorteilhafte Ausgestaltungen der Erfindung sind Gegenstand der Unteransprüche.

Die Erfindung wird nachfolgend anhand von Ausführungsbeispielen unter Zuhilfenahme der Figuren näher erläutert.

Es zeigen:
- Figur 1: anhand eines vereinfachten Blockschaltbildes ein erstes Ausführungsbeispiel des erfindungsgemäßen Zweipunkt-Modulators und
- Figur 2: ein Ausführungsbeispiel eines erweiterten Schleifenfilters zum Einsatz in einem Modulator gemäß Figur 1 anhand eines Schaltplanes.

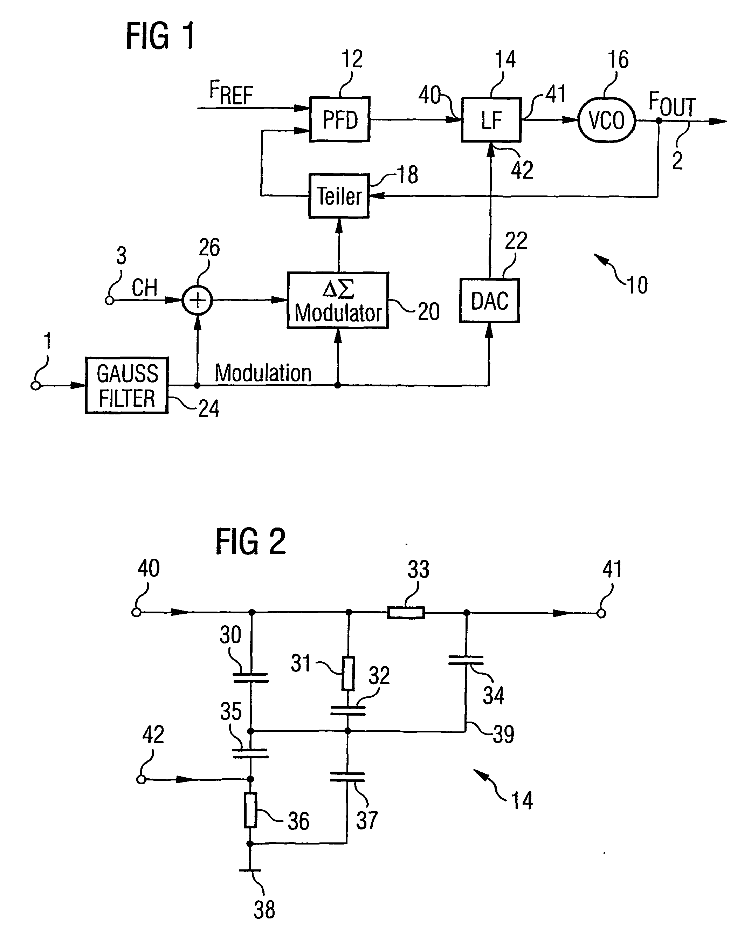

Figur 1 zeigt einen Zweipunkt-Modulator 10, aufweisend einen Modulationseingang 1 zum Zuführen von Modulationsdaten und einen Ausgang 2, an dem ein frequenz- und/oder phasenmoduliertes Signal F_{OUT} ableitbar ist.

Weiterhin ist ein Phasenregelkreis 12, 14, 16, 18 vorgesehen, der einen Phasendetektor 12, ein Schleifenfilter 14, einen spannungsgesteuerten Oszillator 16 und einen Frequenzteiler 18 umfaßt. Der Phasendetektor 12 ist mit einem ersten Eingang an den Ausgang des Frequenzteilers 18 angeschlossen. Mit einem zweiten Eingang, an dem ein Signal mit einer Bezugsfrequenz F_{REF} zugeführt wird, ist eine hier nicht eingezeichnete Bezugsfrequenzquelle verbunden. Der Ausgang des Phasendetektors 12 ist über ein Schleifenfilter 14 an den Steuereingang eines spannungsgesteuerten Oszillators, VCO 16 angeschlossen. Der Ausgang des Oszillators 16 bildet den Ausgang 2 des Modulators 10 und ist weiterhin mit einem Eingang des Frequenzteilers 18 verbunden. Der Frequenzteiler 18 ist als Multi-Modulus-Teiler ausgebildet und weist einen Steuereingang zum Zuführen von Modulationsdaten, genauer zum Zuführen eines von den Modulationsdaten abgeleiteten Signals auf. Ebenso weist das Schleifenfilter 14 einen weiteren Eingang auf, der ebenfalls mit dem Modulationseingang 1 über einen Digital/Analog-Wandler 22 gekoppelt ist. Die Modulationsdaten werden zunächst Gauss-gefiltert, hierfür ist ein Gauss-Filter 24 vorgesehen, welches den Eingang 1 des Modulators mit dem Digital-Analog-Wandler 22 an einem Eingang sowie mit einem Delta-Sigma-Modulator 20 an dessen Eingang koppelt. Der Ausgang des Delta-Sigma-Modulators 20 ist mit dem Steuereingang des Frequenzteilers 18 verbunden. Der Delta-Sigma-Modulator 20 weist weiterhin einen Eingang zur Kanalvorwahl auf, der über ein Summationsglied 26 an einen weiteren Eingang 3 des Modulators ausgebildet zur Zuführung eines Signals zur Kanalvorwahl gekoppelt ist. Das Summationsglied 26 hat einen weiteren Eingang, der über das Gauss-Filter 24 mit dem Eingang 1 des Modulators 10 gekoppelt ist.

Der Frequenzteiler 18 bildet einen Tiefpaß-Einkoppelpunkt zum Zuführen des Modulationssignals oder eines vom Modulationssignal abgeleiteten Signals. Das Schleifenfilter 14 hingegen bildet mit seinem zusätzlichen Einkoppelpunkt gemäß dem vorliegenden Prinzip mit Vorteil einen Hochpaß-Einkoppelpunkt für ein vom Modulationssignal abgeleitetes Signal. Insgesamt ergibt sich eine Zweipunkt-Modulatoranordnung 10, welche Modulationsdaten verarbeiten kann, die eine Bandbreite haben, die größer ist als die Bandbreite der Phasenregelschleife 12, 14, 16, 18 selbst.

Da das Schleifenfilter 14 die Verknüpfung des vom Phasendetektor 12 an dessen Ausgang bereitgestellten Signals und des Modulationssignals, welches vom Digital/Analog-Wandler 22 bereitgestellt wird, bewirkt, kann mit Vorteil ein herkömmlicher, einfach aufgebauter spannungsgesteuerter Oszillator 16 mit lediglich einem Abstimmeingang verwendet werden. Das Schleifenfilter 14 ist bei der Ausführung gemäß Figur 1 als rein passives Filter realisiert, welches lediglich konzentrierte Widerstände und Kondensatoren umfaßt und dadurch insgesamt einen geringen Rauschbeitrag zur Schaltung liefert.

Das erweiterte Schleifenfilter 14 ist dabei so ausgelegt, daß das vom Digital/Analogkonverter 22 bereit gestellte Modulationssignal mit ausreichender Bandbreite und Hochpaß-Eigenschaften an den Abstimmeingang des spannungsgesteuerten Oszillators 16 übertragen werden kann.

Aufgrund der genannten, vorteilhaften Eigenschaften wie geringes Rauschen, geringer Strombedarf et cetera eignet sich der beschriebene Zweipunkt-Modulator von Figur 1 besonders zum Einsatz in Mobilfunk-Sendeeinheiten. Dabei ist der Modulator insbesondere zum Betrieb mit Phasen- und Frequenzmodulation geeignet.

Figur 2 zeigt ein Ausführungsbeispiel für das Schleifenfilter 14, englisch Loop Filter, LF, welches erweitert ist um einen Hochpaß-Einkoppelpunkt zum Zuführen eines Modulationssignals in einer Zweipunkt-Modulation wie in Figur 1 gezeigt. Das Schleifenfilter 14 gemäß Figur 2 gliedert sich in ein herkömmliches Fünf-Elemente-Schleifenfilter 30, 31, 32, 33, 34, welches aus passiven Komponenten, nämlich Widerständen 31, 33 und Kondensatoren 30, 32, 34 aufgebaut ist, sowie in ein Einkoppelglied 35, 36, 37, welches ebenfalls lediglich Kondensatoren und Widerstände umfaßt und als Hochpaß-Einkoppelpunkt zwischen dem Fußpunkt des herkömmlichen Schleifenfilters 30 bis 34 und einem Bezugspotentialanschluß 38 geschaltet ist.

Der herkömmliche Teil des Schleifenfilters 30 bis 34 umfaßt einen gegen den Fußpunkt 39 des herkömmlichen Schleifenfilters geschalteten Kondensator 30, eine dazu parallel geschaltete Serienschaltung aus einem Widerstand 31 und einer Kapazität 32 sowie ein nachgeschaltetes Tiefpaß-Filter 33, 34, welches als RC-Glied aufgebaut ist. Insoweit ist der herkömmliche Teil des Schleifenfilters 30 bis 34 zwischen Eingang 40 und Ausgang 41 des Schleifenfilters 14 geschaltet. Eingang 40 des Schleifenfilters ist, gegebenenfalls über eine Ladungspumpenschaltung, an den Ausgang des Phasendetektors 12 angeschlossen, während der Ausgang 41 des Schleifenfilters 14 mit dem Eingang eines gesteuerten Oszillators 16 von Figur 1 verbunden ist. Zwischen Fußpunkt 39 des herkömmlichen Schleifenfilters 30 bis 34 und Bezugspotentialanschluß 38 ist als Erweiterung gemäß dem vorliegenden Prinzip das Koppelglied 35 bis 37 geschaltet, welches eine Serienschaltung aus einem Kondensator 35 und einem Widerstand 36 und einem zu dieser Serienschaltung parallel geschalteten Kondensator 37 umfaßt. Zwischen Kondensator 35 und Widerstand 36 ist an deren gemeinsamem Verbindungsknoten der weitere Eingang 42 des Schleifenfilters 14 gebildet, der gerade den Hochpaß-Einkoppelpunkt des Zweipunkt-Modulators gemäß Figur 1 und dem erfinderischen Prinzip bildet.

Es wird deutlich, daß mit lediglich drei konzentrierten Bauteilen, welche alle passive elektronische Bauteile sind, nämlich Widerstände und Kondensatoren 35 bis 37, das Schleifenfilter 14 gemäß vorliegendem Prinzip mit einem Koppelglied weitergebildet ist. Da die beschriebene Schaltungsanordnung keine zusätzlichen aktiven Komponenten einführt, sind die zusätzlichen Rauschanteile der Modulatoranordnung gemäß dem vorliegenden Prinzip gering. Mit Vorteil wird die Modulation des Zweipunkt-Modulators am Fußpunkt des herkömmlichen Schleifenfilters 30 bis 34 eingebracht. Das Schleifenfilter 14 koppelt damit die mittels des Frequenzteilers 18 eingebrachte Modulation mit Tiefpaßverhalten und die am Hochpaßpunkt 42 eingebrachte Modulation mit Vorteil so miteinander, daß die Bandbreite des Modulationssignals höher sein kann als die Bandbreite der Regelschleife 12, 14, 16, 18 von Figur 1.

Selbstverständlich liegt es im fachmännischen Handeln und im Rahmen des vorliegenden Prinzips, anstelle des in Figur 2 gezeigten Schleifenfilters auch andere Schleifenfilter, die gemäß vorliegendem Prinzip einen zusätzlichen Modulationseingang mit Hochpaß-Eigenschaften bilden, in einem Modulator 10 gemäß Figur 1 vorzusehen.

Der beschriebene Zweipunkt-Modulator ist mit Vorteil als integrierte Schaltung ausgebildet.

### Bezugszeichenliste

- 1: Eingang
- 2: Ausgang
- 3: Kanalwahl-Eingang
- 10: Modulator
- 12: Phasendetektor
- 14: Schleifenfilter
- 16: VCO
- 18: Teiler
- 20: Delta-Sigma-Modulator
- 22: Digital-Analog-Wandler
- 24: Gauss-Filter
- 26: Summationsglied
- 30: Kondensator
- 31: Widerstand
- 32: Kondensator
- 33: Widerstand
- 34: Kondensator
- 35: Kondensator
- 36: Widerstand
- 37: Kondensator
- 38: Bezugspotentialanschluß
- 39: Fußpunkt
- 40: Eingang
- 41: Ausgang
- 42: weiterer Eingang

## Patentansprüche

1. Zweipunkt-Modulatoranordnung, aufweisend
- einen Modulationseingang (1) zum Zuführen von Modulationsdaten,
- einen Ausgang (2) zum Ableiten eines modulierten Signals, und
- einen Phasenregelkreis (12, 14, 16, 18),
mit einem Phasenvergleicher (12), der einen ersten und einen zweiten Eingang und einen Ausgang umfaßt, mit einem steuerbaren Oszillator (16), der einen Steuereingang und einen Ausgang umfaßt,
mit einem Schleifenfilter (14), das einen Eingang hat, der mit dem Ausgang des Phasenvergleichers (12) gekoppelt ist, und das einen Ausgang hat, der mit dem Eingang des oszillators (16) verbunden ist,
- mit einem Rückkopplungspfad des Phasenregelkreises, wobei im Rückkopplungspfad ein Frequenzteiler (18) angeordnet ist, der einen Eingang, welcher mit dem Ausgang des Oszillators (16) verbunden ist, einen Ausgang, welcher mit dem ersten Eingang des Phasenvergleichers (12) verbunden ist und einen Steuereingang zum Einstellen des Teilerverhältnisses, der mit dem Modulationseingang (1) der Modulatoranordnung gekoppelt ist, aufweist,
**dadurch gekennzeichnet, daß**
- das Schleifenfilter einen weiteren Eingang (42) hat, der aus einem mit dem Schleifenfilter (14) verbundenen Einkoppelglied (35, 36, 37) gebildet und mit dem Modulationseingang (1) der Modulatoranordnung gekoppelt ist, wobei das Einkoppelglied (35, 36, 37) zwischen einen Schaltungsknoten (39) des Schleifenfilters und einen Bezugspotentialanschluß (38) geschaltet und als Hochpaß-Einkoppelpunkt des Zweipunkt-Modulators ausgebildet ist.

2. Modulatoranordnung nach Anspruch 1,
**dadurch gekennzeichnet, daß**
das mit dem Schleifenfilter (14) gekoppelte Einkoppelglied (35, 36, 37) passiv aufgebaut ist und zumindest einen Widerstand (36) und eine Kapazität (35) umfaßt.

3. Modulatoranordnung nach Anspruch 1 oder 2,
**dadurch gekennzeichnet, daß**
das mit dem Schleifenfilter (14) gekoppelte Einkoppelglied (35, 36, 37) eine Parallelschaltung aus einem Kondensator (37) und aus einer Serienschaltung aufweisend einen Kondensator (35) und einen Widerstand (36) umfaßt.

4. Modulatoranordnung nach einem der Ansprüche 1 bis 3,
**dadurch gekennzeichnet, daß**
das Schleifenfilter (14) eine Kapazität (30), welche gegen den Schaltungsknoten (39) des Schleifenfilter geschaltet ist, eine parallel zur Kapazität (30) geschaltete Serienschaltung umfassend einen Widerstand (31) und eine Kapazität (32) sowie ein RC-Tiefpaßglied (33, 34) umfaßt.

5. Modulatoranordnung nach einem der Ansprüche 1 bis 4,
**dadurch gekennzeichnet, daß**
zur Aufbereitung der Modulationsdaten ein Delta-Sigma-Modulator (20), der den Modulationseingang (1) mit dem Frequenzteiler (18) des Phasenregelkreises koppelt und ein Digital-/Analog-Wandler (22) vorgesehen ist, der den Modulationseingang (1) mit dem Einkoppelglied (35, 36, 37) am Schleifenfilter (14) des Phasenregelkreises koppelt.

6. Modulatoranordnung nach einem der Ansprüche 1 bis 5,
**dadurch gekennzeichnet, daß**
der Frequenzteiler (18) des Phasenregelkreises als Tiefpaß-Einkoppelpunkt des Phasenregelkreises ausgelegt ist.

7. Modulatoranordnung nach einem der Ansprüche 1 bis 6,
**dadurch gekennzeichnet, daß**
der Frequenzteiler (18) des Phasenregelkreises mit einem Eingang (3) der Modulatoranordnung ausgelegt zum Zuführen eines Signals zur Kanalvorwahl ausgebildet ist.

## Claims

1. A two-point modulator arrangement having
- a modulation input (1) for supplying modulation data,
- an output (2) for discharging a modulated signal, and
- a phase locked loop (12, 14, 16, 18)
having a phase comparator (12), which comprises a first and a second input and an output,
having a controllable oscillator (16), which comprises a control input and an output,
having a loop filter (14), which has an input that is coupled to the output of the phase comparator (12) and an output that is connected to the input of the oscillator (16),
- having a feedback path of the phase locked loop, a frequency divider (18) being arranged in the feedback path, said frequency divider having an input that is connected to the output of the oscillator (16), an output that is connected to the first input of the phase comparator (12) and a control input for setting the divider ratio that is coupled to the modulation input (1) of the modulator arrangement,
**characterized in that**
- the loop filter has a further input (42) that is formed by a coupling-in element (35, 36, 37) - which is connected to the loop filter (14) - and is coupled to the modulation input (1) of the modulator arrangement, the coupling-in element (35, 36, 37) being connected between a circuit node (39) of the loop filter and a reference potential terminal (38) and being in the form of a high-pass coupling-in point of the two-point modulator.

2. The modulator arrangement as claimed in claim 1,
**characterized in that**
the coupling-in element (35, 36, 37) that is coupled to the loop filter (14) is of passive construction and comprises at least one resistor (36) and a capacitance (35).

3. The modulator arrangement as claimed in claim 1 or 2,
**characterized in that**
the coupling-in element (35, 36, 37) that is coupled to the loop filter (14) comprises a parallel circuit formed from a capacitor (37) and from a series circuit having a capacitor (35) and a resistor (36).

4. The modulator arrangement as claimed in one of claims 1 to 3,
**characterized in that**
the loop filter (14) comprises a capacitance (30) that is connected to the circuit node (39) of the loop filter, a series circuit - comprising a resistor (31) and a capacitance (32) - that is connected in parallel with the capacitance (30) and also an RC low-pass filter element (33, 34).

5. The modulator arrangement as claimed in one of claims 1 to 4,
**characterized in that**
a delta-sigma modulator (20), which couples the modulation input (1) to the frequency divider (18) of the phase locked loop, and a digital-to-analog converter (22), which couples the modulation input (1) to the coupling-in element (35, 36, 37) at the loop filter (14) of the phase locked loop, are provided for the purpose of conditioning the modulation data.

6. The modulator arrangement as claimed in one of claims 1 to 5,
**characterized in that**
the frequency divider (18) of the phase locked loop is in the form of a low-pass coupling-in point of the phase locked loop.

7. The modulator arrangement as claimed in one of claims 1 to 6,
**characterized in that**
the frequency divider (18) of the phase locked loop is designed with an input (3) of the modulator arrangement designed to supply a signal for channel preselection.

## Revendications

1. Ensemble modulateur à deux points, comprenant
- une entrée (1) de modulation pour l'entrée de données de modulation ;
- une sortie (2) de sortie d'un signal modulé ; et
- une boucle (12, 14, 16, 18) à verrouillage de phase,
ayant un comparateur (12) de phase qui comporte une première et une deuxième entrées et une sortie,
ayant un oscillateur (16) pouvant être commandé et comportant une entrée de commande et une sortie,
ayant un filtre (14) à boucle, qui a une entrée couplée à la sortie du comparateur (12) de phase et qui a une sortie reliée à l'entrée de l'oscillateur (16),
- ayant un trajet de réaction de la boucle à verrouillage de phase, un diviseur (18) de fréquence étant monté dans le trajet de réaction et ayant une entrée qui est reliée à la sortie de l'oscillateur (16), une sortie qui est reliée à la première entrée du comparateur (12) de phase et une entrée de commande pour régler le rapport de division qui est couplé à l'entrée (1) de modulation de l'ensemble modulateur,
**caractérisé en ce que**
- le filtre à boucle a une autre entrée (42) qui est formée d'un élément (35, 36, 37) d'injection relié au filtre (14) à boucle et qui est couplée à l'entrée (1) de modulation de l'ensemble modulateur, l'élément (35, 36, 37) d'injection étant monté entre un noeud (39) de circuit du filtre à boucle et une borne (38) de potentiel de référence et étant constitué en point d'injection passe-haut du modulateur à deux points.

2. Ensemble modulateur suivant la revendication 1, **caractérisé en ce que** l'élément (35, 36, 37) d'injection couplé au filtre (14) à boucle est constitué de façon passive et comprend au moins une résistance (36) et une capacité (35).

3. Ensemble modulateur suivant la revendication 1 ou 2, **caractérisé en ce que** l'élément (35, 36, 37) d'injection couplé au filtre (14) à boucle comprend un circuit parallèle constitué d'un condensateur (37) et d'un circuit série comprenant un condensateur (35) et une résistance (36).

4. Ensemble modulateur suivant l'une des revendications 1 à 3, **caractérisé en ce que** le filtre (14) à boucle comprend une capacité (30) qui est montée contre le noeud (39) du circuit du filtre à boucle, un circuit série monté en parallèle à la capacité (30) et comprenant une résistance (31) et une capacité (32), ainsi qu'un élément (33, 34) passe-bas RC.

5. Ensemble modulateur suivant l'une des revendications 1 à 4, **caractérisé en ce qu'**il est prévu pour la préparation des données de modulation un modulateur (20) Delta-Sigma qui couple l'entrée (1) de modulation au diviseur (18) de fréquence de la boucle à verrouillage de phase et un convertisseur (22) numérique/analogique qui couple l'entrée (1) de modulation à l'élément (35, 36, 37) d'injection du filtre (14) à boucle de la boucle à verrouillage de phase.

6. Ensemble modulateur suivant l'une des revendications 1 à 5, **caractérisé en ce que** le diviseur (18) de fréquence de la boucle à verrouillage de phase est conçu en tant que point d'injection passe-bas de la boucle à verrouillage de phase.

7. Ensemble modulateur suivant l'une des revendications 1 à 6, **caractérisé en ce que** le diviseur (18) de fréquence de la boucle à verrouillage de phase est constitué en étant conçu avec une entrée (13) de l'ensemble modulateur pour l'entrée d'un signal de présélection de canal.
